# EUROPÄISCHE PATENTANMELDUNG

(11) **EP 1 172 818 A1**
(43) Veröffentlichungstag der Anmeldung: **16.01.2002**
(21) Anmeldenummer: 00115138.0
(22) Anmeldetag: 12.07.2000
(51) Int. Cl.: G11B 33/14, H05K 5/02

(54) **Datensicherungseinrichtung**

(71) Anmelder: format Tresorbau GmbH & Co. KG, 37235 Hessisch Lichtenau (DE)
(72) Erfinder: Schmidt, E.-Michael Dipl.-Ing., 97074 Würzburg (DE)
(74) Vertreter: WALTHER, WALTHER & HINZ Patentanwälte

(57) **Zusammenfassung**

Im Gehäuse eines Rechners anbringbare Datensicherungseinrichtung, z. B. eine Festplatte, wobei die Datensicherungseinrichtung (20) in einem hitzebeständigen Gehäuse (1) angeordnet ist.

## Beschreibung

Die Erfindung betrifft eine in einem Gehäuse eines Rechners anbringbare Datensicherungseinrichtung, z. B. eine Festplatte, bzw. das Gehäuse eines Rechners mit einer Datensicherungseinrichtung, z. B. eine Festplatte.

Datensicherungseinrichtungen beispielsweise in Form einer Festplatte sind bekannt. Derartige Festplatten befinden sich überlicherweise im Gehäuse eines Rechners. Eine solche Datensicherungseinrichtung speichert sämtliche Daten des Rechners im Wesentlichen über den gesamten Lebenszyklus des Rechners.

Es ist daher unbedingt erforderlich, derartige Datensicherungseinrichtungen oder auch Datenspeicher gegen Datenverlust zu sichern. Bekannt hierbei sind sogenannte redundante Systeme oder auch externe Sicherungseinrichtungen, beispielsweise in Form von Bändern, wie im Rechner angeordnete Bandlaufwerke, die mit den Daten der Festplatte beschrieben werden. Die zuvor bereits genannten redundanten Systeme zeichnen sich dadurch aus, dass im Rechnergehäuse zwei Festplatten vorhanden sind, deren Daten gegenseitig gespiegelt werden.

In obiger Weise gesicherte Daten bieten Schutz vor einem Datenverlust, wenn beispielsweise der Rechner abstürzt. Allerdings wird durch diese bekannten Systeme kein Schutz vor beispielsweise Feuer bewirkt.

Der Erfindung liegt daher die Aufgabe zu Grunde eine Datensicherungseinrichtung, z. B. eine Festplatte, bereitzustellen, die auch gegen Feuer bzw. ganz allgemein gegen Hitzeinwirkungen von außen geschützt ist.

Die Aufgabe wird erfindungsgemäß dadurch gelöst, dass die Datensicherungseinrichtung in einem hitzbeständigen Gehäuse angeordnet ist. Im Einzelnen ist hierbei vorgesehen, dass das Gehäuse mehrwandig und hier insbesondere doppelwandig ausgebildet ist. Durch eine insbesondere doppelwandige Ausbildung des Gehäuses wird bereits eine erhebliche Isolierwirkung erzielt. Erhöht werden kann diese Isolierwirkung noch dadurch, dass der Hohlraum zwischen zwei Wandungen mit einem Mittel ausgefüllt ist, das den Gehäuseinnenraum gegen Hitzeeinwirkung schützt. Ein solches Mittel ist beispielsweise ein Salz, vorzugsweise jedoch ein Gemisch aus Salz und einem Bindemittel als Matrixmaterial für das Salz. Salz besitzt die Fähigkeit, chemisch viel Wasser an sich zu binden und dieses Wasser schon bei Temperaturen um ca. 30 Grad wieder abzuspalten. Bei diesem chemischen Prozess wird ohne Temperaturerhöhung das Salz von der kristallinen in die flüssige Form übergehen und somit Energie aus seiner Umgebung aufnehmen. Erst wenn das Salz in dieser Wandschicht durch den äußeren Temperatureinfluß in die flüssige Form übergegangen ist, kann eine Temperaturerhöhung in diesem Wandabschnitt eintreten und in den Innenraum übergreifen, was jedoch durch eine optimale Dimensionierung der einzelnen Wandschichten verhindert werden kann.

Im Einzelnen ist vorgesehen, dass das Bindemittel ein Isolierputz, Leichtbeton, Gips oder ein Vermiculite ist.

Nach einem besonders vorteilhaften Merkmal der Erfindung ist das Salz bzw. das Gemisch aus Salz und Bindmittel in fester Form in der Wandung des Gehäuses angeordnet. Der Vorteil einer derart festen Form gegenüber einer Schüttung besteht darin, dass eine derartige feste Form im Gegensatz zu einer Schüttung nicht im Laufe der Zeit auf Grund der Schwerkraft zusammensackt. Das heißt, dass bei einer Schüttung beispielsweise im oberen Bereich des Gehäuses nach einiger Zeit keine derartige Schüttung mehr vorhanden ist, mit der Folge, dass an diesen Stellen das Gehäuse bei entsprechender Hitzeeinwirkung durchbrennt. Nachteile einer derartigen Schüttung ergeben sich insbesondere auch dann, wenn das Gehäuse stoßartigen Belastungen ausgesetzt ist. Dies deshalb, weil insbesondere nach stoßartigen Belastungen eine derartige Schüttung zusammensackt, mit der Folge, dass bei der nachfolgenden Beflammung das Gehäuse an den entsprechenden Stellen durchbrennt. Im Einzelnen ist in Bezug auf diese Variante vorgesehen, dass die feste Form die Form einer Platte bzw. die Form der Kontur des Gehäuses insgesamt entspricht.

Um zu verhindern, dass beispielsweise durch punktuelle Wärmeeinwirkung an bestimmten Stellen das in der Wandung angeordnete Material Flüssigkeit verliert ist vorgesehen, dass das Salz bzw. das Gemisch aus Salz und Bindemittel in Kunststoffbeuteln eingelagert wird. Hierdurch wird verhindert, dass das Wasser bei einer derartiger punktueller Wärmeeinwirkung, wie beispielsweise durch Sonneeinstrahlung nicht aus dem Gehäuse austreten kann. Es besteht zwar weiterhin die Möglichkeit, dass das im Salz gebundene Wasser bei derartiger Wärmeauswirkung aus dem Salz austritt, durch die luftdichte Verpackung und die hygroskopischen Eigenschaften des Salzes wird es allerdings bei Erkalten wieder in die kristalline Form übergehen. Das heißt, es ist hierdurch sichergestellt, dass in jedem Fall das Salz mit dem darin gebundenen Wasser zum Schutze des Innenraumes des Gehäuses gegen Temperaturerhöhung auch noch nach Jahren zur Verfügung steht.

Nach einem besonders vorteilhaften Merkmal ist der Kunststoffbeutel mit einer Aluminiumschicht kaschiert. Diese Aluminiumschicht, die insbesondere nach außen gerichtet ist, hat den Vorteil, dass durch sie die Wärme reflektiert, abgeleitet und verteilt wird. Nach einem weiteren Merkmal der Erfindung ist das Salz bzw. das Gemisch aus Salz und Bindemittel durch eine Isolierschicht zur Außenseite des Gehäuses hin abgeschirmt. Eine derartige Isolierschicht, beispielsweise aus geschäumtem Kunststoff, bewirkt eine Verbesserung des Temperaturgradienten, mit der Folge, dass die Wandstärke bei gleichbleibender Temperaturbeständigkeit abnehmen kann. Die Folge hiervon wiederum ist, dass das Rechnergehäuse selbst nicht übermäßig großdimensioniert werden muß, um eine solche Datensicherungseinrichtung samt Gehäuse aufnehmen zu können.

Das zuvor beschriebene Gehäuse für eine Datensicherungseinrichtung kann bei entsprechender Auslegung die Prüfung nach VDMA-24991/1 oder 2 bzw. EN 1047/1 oder 2 für einen Wertschutzschrank bestehen. Bei einer solchen Prüfung wird das Gehäuse bei einem Zeitraum von ein bis zwei Stunden einer Umgebungstemperatur von 1090° C ausgesetzt. Alsdann würde im glühenden Zustand des Gehäuses, das Gehäuse aus einer Höhe von 9,5 m in ein Kiesbett gestürzt. Nach dem Sturz findet wieder eine Erhöhung auf 1090° C statt, wobei es dann über einen mindestens 12-stündigen Zeitraum im abgeschalteten Ofen abkühlen muß. Selbst während dieser Abkühlphase, darf nach den oben genannten Richtlinien an keiner Stelle innerhalb des Gehäuses eine Temperatur von mehr als 50 Grad erreicht werden.

Es ist bekannt, dass derartige Datensicherungseinrichtungen der zuvor beschriebenen Art während ihres Betriebes Wärme entwickeln. Einsichtig ist ebenfalls, dass ein Gehäuse der zuvor beschriebenen Art - sofern es gegen Hitzeeinwirkung von außen schützt, auch die Wärme, die im Inneren durch den Betrieb, beispielsweise in einer Festplatte auftritt, nicht nach außen ableiten kann. Gegenstand der Erfindung ist daher eine dem Gehäuse zugeordnete Kühleinrichtung. Eine solche Kühleinrichtung umfasst ein im Gehäuseinneren angeordnetes Kühlaggregat. Durch dieses Kühlaggregat wird die im Inneren des Gehäuses während des Betriebs beispielsweise der Festplatte entstehende Wärme abgeführt. Vorteilhaft besitzt die Kühleinrichtung ein externes Kühlaggregat, das mit dem im Gehäuseinneren angeordneten Kühlaggregat derart in Wirkverbindung steht, dass die von dem im Gehäuseinneren angeordneten Kühlaggregat aufgenommene Wärme durch das externe Kühlaggregat an die Umgebung abgeleitet werden kann. Das interne Kühlaggregat kann hierbei als flüssigkeitsgekühlter Kühlkörper ausgebildet sein, das Kühlaggregat als Wärmetauscher.

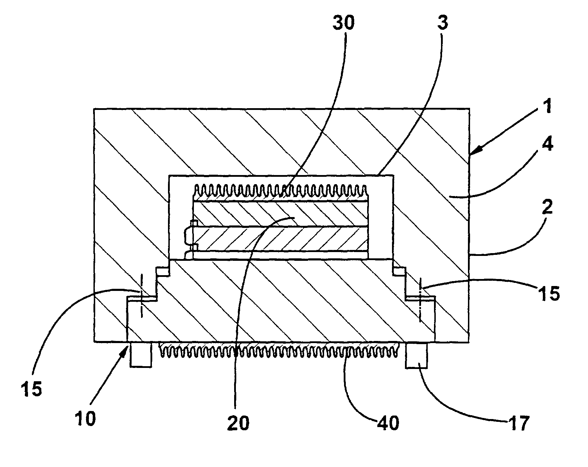

Anhand der Zeichnung wird die Erfindung nachstehend beispielhaft näher erläutert. Hierbei zeigt die dargestellte Figur schematisch das Gehäuse sowie die im Gehäuse angeordnete Datensicherungseinrichtung im Schnitt. Das Gehäuse 1 zeigt die beiden Wandungen 2 und 3, die einen Hohlraum 4 bilden, der mit einem Salz bzw. einem Salzgemisch ausgefüllt ist. Das Gehäuse 1 zeigt darüber hinaus den Gehäuseboden 10, der vorteilhaft die Datensicherungseinrichtung 20 beispielsweise in Form einer Festplatte trägt.

Im vorliegenden Fall zeigt die Datensicherungseinrichtung das Kühlaggregat 30. Dieses Kühlaggregat 30 steht mit dem externen Kühlaggregat 40, das auf der äußeren Seite des Gehäusebodens 10 angeordnet ist, derart in Verbindung, dass die von der Datensicherungseinrichtung 20 erzeugte Wärme durch dieses äußere Kühlaggregat abgeleitet werden kann. Der Boden 10, der beispielsweise mittels Schrauben 15 mit dem übrigen Gehäuse verbunden ist, besitzt Füsse 17, zwischen denen das externe Kühlaggregat 40 angeordnet ist.

## Patentansprüche

1. Im Gehäuse eines Rechners anbringbare Datensicherungseinrichtung, z. B. eine Festplatte,
**dadurch gekennzeichnet,**
**dass** die Datensicherungseinrichtung (20) in einem hitzebeständigen Gehäuse (1) angeordnet ist.

2. Datensicherungseinrichtung nach Anspruch 1,
**dadurch gekennzeichnet,**
**dass** das Gehäuse (1) eine Kühleinrichtung (30, 40) aufweist.

3. Datensicherungseinrichtung nach Anspruch 2,
**dadurch gekennzeichnet,**
**dass** die Kühleinrichtung (30, 40) ein im Gehäuseinneren angeordnetes Kühlaggregat (30) umfasst.

4. Datensicherungseinrichtung nach Anspruch 2 oder 3,
**dadurch gekennzeichnet,**
**dass** die Kühleinrichtung (30, 40) ein externes Kühlaggregat (40) umfasst.

5. Datensicherungseinrichtung nach Anspruch 3 und 4,
**dadurch gekennzeichnet,**
**dass** die beiden Kühlaggregate (30, 40) miteinander in Verbindung stehen.

6. Datensicherungseinrichtung nach Anspruch 1,
**dadurch gekennzeichnet,**
**dass** das Gehäuse (1) mehrwandig, insbesondere doppelwandig ausgebildet ist.

7. Datensicherungseinrichtung nach Anspruch 6,
**dadurch gekennzeichnet,**
**dass** der Hohlraum zwischen zwei Wandungen (2, 3) mit einem Mittel ausgefüllt ist, das den Gehäuseinneraum gegen Hitzeinwirkung schützt.

8. Datensicherungseinrichtung nach Anspruch 7,
**dadurch gekennzeichnet,**
**dass** das Mittel ein Salz ist.

9. Datensicherungseinrichtung nach Anspruch 8,
**dadurch gekennzeichnet,**
**dass** das Salz ein Bindemittel, z. B. Isolierputz, Gips oder Vermiculite für das Salz aufweist.

10. Datensicherungseinrichtung nach Anspruch 8 oder 9,
**dadurch gekennzeichnet,**
**dass** das Salz bzw. das Gemisch aus Salz und Bindemittel in fester Form in der Gehäusewandung angeordnet ist.

11. Datensicherungseinrichtung nach Anspruch 10,
**dadurch gekennzeichnet,**
**dass** die feste Form die Form einer Platte aufweist.

12. Datensicherungseinrichtung nach Anspruch 8 oder 9,
**dadurch gekennzeichnet,**
**dass** das Salz oder das Gemisch aus Salz oder Bindemittel luft- und wasserdicht verpackt ist.

13. Datensicherungseinrichtung nach Anspruch 12,
**dadurch gekennzeichnet,**
**dass** das Salz oder das Gemisch aus Salz und Bindemittel in einem Kunststoffbeutel lagert.

14. Datensicherungseinrichtung nach Anspruch 13,
**dadurch gekennzeichnet,**
**dass** der Kunststoffbeutel mit einer Aluminiumschicht kaschiert ist.

15. Datensicherungseinrichtung nach Anspruch 8 oder 9,
**dadurch gekennzeichnet,**
**dass** das Salz bzw. das Gemisch aus Salz und Bindemittel durch eine Isolierschicht zur Außenseite des Gehäuses hin abgeschirmt ist.

16. Datensicherungseinrichtung nach Anspruch 9,
**dadurch gekennzeichnet,**
**dass** das Salz feinverteilt in dem Bindemittel als Matrixmaterial eingebettet ist.

17. Gehäuse eines Rechners mit einer Datensicherungseinrichtung, z. B. einer Festplatte,
**dadurch gekennzeichnet,**
**dass** die Datensicherungseinrichtung ein Gehäuse gemäß einem oder mehrerer der Ansprüche 1 bis 16 aufweist.
